Europäisches Patentamt

European Patent Office

Office européen des brevets

(19)

(11) Publication number: 0 306 069

A2

## (12) EUROPEAN PATENT APPLICATION

(21) Application number: 88201663.7

(22) Date of filing: 02.08.88

(51) Int. Cl.4: C23C 16/40 , C23C 16/48 , C23C 14/34 , H01L 21/316

(30) Priority: 31.08.87 US 91678

(43) Date of publication of application:
08.03.89 Bulletin 89/10

(84) Designated Contracting States:
DE FR GB IT NL SE

(71) Applicant: N.V. Philips' Gloeilampenfabrieken
Groenewoudseweg 1
NL-5621 BA Eindhoven(NL)

(72) Inventor: Ramesh, Subramanian
c/o INT. OCTROOIBUREAU B.V. Prof.
Holstlaan 6
NL-5656 AA Eindhoven(NL)
Inventor: Dobson, Peter James
c/o INT. OCTROOIBUREAU B.V. Prof.
Holstlaan 6
NL-5656 AA Eindhoven(NL)
Inventor: Curran, James Edward
c/o INT. OCTROOIBUREAU B.V. Prof.
Holstlaan 6
NL-5656 AA Eindhoven(NL)

(74) Representative: Clark, Jane Anne et al
PHILIPS ELECTRONICS Patents and Trade
Marks Department Centre Point New Oxford
Street
London WC1A 1QJ(GB)

(54) A method of forming an oxide layer on a substrate.

(57) A method of forming an oxide layer on a substrate includes supplying an oxygen-containing gas to a chamber containing a substrate, providing defect oxide material within the chamber and irradiating the substrate with an electromagnetic radiation source, for example using an ultra-violet laser or an ultra-violet lamp, to cause photolytic dissociation of the oxygen-containing gas to provide oxygen atoms in the vicinity of the defect oxide material within the chamber so that oxygen atoms are incorporated in the defect oxide material to provide a layer of defect oxide material with desired oxygen content on the substrate. The defect oxide material with the desired oxygen content may be a high temperature superconducting mixed oxide such as $YBa_2Cu_3O_{6.8}$.

FIG.1

## A METHOD OF FORMING AN OXIDE LAYER ON A SUBSTRATE

### FIELD OF THE INVENTION

This invention relates to a method of forming an oxide layer on a substrate.

### BACKGROUND OF THE INVENTION

As described in, for example, Physical Review Letters 20th April, 1987 Vol 58 No 16 at pages 1676 to 1679 and various papers in the special section on high Tc oxide superconductors published in the Japanese Journal of Applied Physics Part 2 Vol 26 (1987) No 4, recently ceramic materials have been produced which are capable of becoming superconducting at high temperatures, that is around 90-100 K (degrees Kelvin). These ceramic materials comprise, as described in the afore-mentioned papers, mixed oxides of rare earth, barium (or calcium or strontium) and copper, having a defect oxide structure, for example in the form of a distorted oxygen deficient perovskite structure. The rare earth may, for example, be lanthanum or yttrium which although not strictly a rare earth (that is a member of the lanthanide series) has very similar properties.

The oxygen content of these mixed oxides is considered to be of importance in providing the mechanism for superconductivity and in determining the abruptness of the transition to and from the superconducting state and , particularly for mixed defect oxides of the general formula $L_aA_bB_cO_{7-x}$ - (where L is a lanthanide or yttrrium, A is strontium, barium or calcium, B copper and $0 < x < 1$), the degree of oxygen deficiency required (as indicated by the value of x) for the material to be a high temperature superconductor is rather precisely defined. Thus, for example, for $YBa_2Cu_3O_{7-x}$ it seems that x should be 0.1 or 0.2, preferably less than 0.1.

Bulk samples of such mixed oxides can be made by a variety of techniques (see the afore-mentioned papers) all of which involve sintering at approximately 950 degrees Celsius for several hours in an oxygen containing atmosphere. Thin films can be prepared by sputtering or evaporating the bulk material, but a high temperature (approximately 950 degrees Celsius) oxygen treatment is usually then needed to restore the correct degree of oxygen deficiency and the high temperature superconductivity properties. Other thin film technologies such as spray pyrolysis or plasma spraying can be used, but again a high substrate temperature is necessary. Such high temperatures are undesirable since they restrict the choice of substrates and other processing technologies which may be used and therefore make it difficult to combine the preparation of such thin films with semiconductor, for example silicon, processing technology as is necessary if integrated devices are to be made.

### SUMMARY OF THE INVENTION

According to a first aspect of the present invention, there is provided a method of forming an oxide layer on a substrate. which method comprises supplying an oxygen-containing gas to a chamber containing a substrate, providing defect oxide material within the chamber and irradiating the substrate with an electromagnetic radiation source to cause photolytic dissociation of the oxygen-containing gas to provide oxygen atoms in the vicinity of the defect oxide material within the chamber so that oxygen atoms are incorporated in the defect oxide material to provide a layer of defect oxide material with a desired oxygen content on the substrate.

The electromagnetic radiation source is preferably an ultraviolet source, such as a laser, or an ultra-violet lamp with a wavelength or range of wavelengths in the range of from 160nm to 250nm.

As used herein, the term defect oxide should be understood to mean an oxide, such as a mixed oxide, which is oxygen deficient and non-stoichiometric, one example of a defect oxide material is the high temperature superconducting mixed oxide $YBa_2Cu_3O_{6.8}$ which if stoichiometric and not deficient in oxygen would have the formula $YBa_2CU_3O_9$.

A method embodying the invention thus enables the oxygen content of a layer of defect oxide material to be adjusted without the need for high temperature processing so facilitating combining of the techniques necessary for producing such films with semiconductor processing technology.

The desired oxygen-annealing of the superconducting material at lower temperatures and also for shorter time periods is believed to be a result of the creation of ozone or oxygen in a singlet state in the reaction chamber, the ozone or singlet-state oxygen being far more reactive than normal oxygen thus enhancing the annealing, oxidation, or other desired reaction and also improving the uniformity of the oxygen-annealing effect. This improved processing will be effective for bulk materials as well as for layers or films but the application to the latter will be more significant.

The defect oxide material may be provided as a layer on the substrate. The defect oxide material may be deposited onto the substrate whilst irradiating the substrate to cause photolytic dissociation of the oxygen-containing gas to provide oxygen atoms to be incorporated in the material being deposited. The defect oxide material may be deposited on the substrate using, for example, a sputtering, spray pyrolysis or plasma spraying technique.

Detecting means may be used to provide a signal indicating the oxidation state of defect oxide material on the substrate and supplying the signal to control means for controlling the electromagnetic radiation source and/or the supply of oxygen-containing gas. Thus, the oxygen content of the defect oxide material on the substrate may be monitored and the electromagnetic radiation source controlled to enable a desired oxygen content to be attained. The detecting means may comprise a further electromagnetic radiation source directed at the substrate and means for detecting electromagnetic radiation from the further electromagnetic radiation source reflected from the defect oxide material on the substrate. Thus, the oxygen content may be monitored by examining the reflectance spectrum of the defect oxide material layer on the substrate and using spectral features which are indicative of the desired oxidation state of one or more elements within the defect oxide material layer for controlling the electromagnetic radiation source and/or the supply of oxygen-containing gas.

Alternatively or additionally, detecting means may be used to provide a signal indicating the resistivity and/or the magnetic susceptibility of the defect oxide material on the substrate and supplying the signal to control means for controlling the electromagnetic radiation source and/or the supply of oxygen-containing gas. A method embodying the invention may comprise using as the defect oxide material a high temperature superconductor mixed oxide comprising oxides of copper and one or more of the elements of the group consisting of the lanthanides and yttrium. Thus, for example, the mixed oxide may be of the general formula $L_aA_bB_cO_{7-x}$, where L is selected from the group consisting of yttrium and the lanthanides, A is selected from the group consisting of strontium, barium and calcium, B is copper, x lies in the range $0 < x < 1$, preferably in the range $0 < x < 0.5$, and a, b, c, indicate relative proportions of L, A, B.

The mixed oxide may be $LBa_2Cu_3O_{7-x}$, a, b, c, normally being, as indicated, in the ratio 1 : 2 : 3.

In a second aspect, the present invention provides a method of manufacturing a semiconductor device whenever using a method in accordance with the first aspect and/or an oxide layer formed by a method in accordance with the first aspect of the invention.

## BRIEF DESCRIPTION OF THE DRAWINGS

Embodiments of the invention will now be described, by way of example, with reference to the accompany drawings, in which:

Figure 1 illustrates diagrammatically, and partly in section and not to scale, apparatus for carrying out a first method embodying the invention; and

Figure 2 illustrates diagrammatically, and partly in section and not to scale, apparatus for carrying out a second method embodying the invention.

## DETAILED DESCRIPTION OF EMBODIMENTS

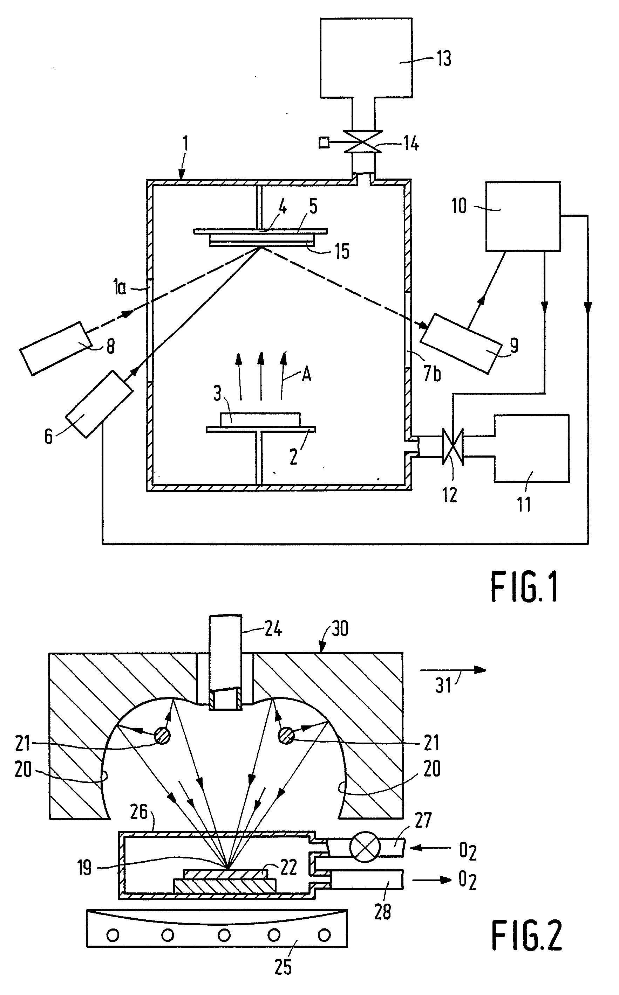

Referring now to be drawing, the apparatus illustrated in Figure 1 comprises a conventional evaporation or sputtering chamber 1 having a first support 2 for a source of the material to be evaporated or sputtered, and a second support 4 for a substrate 5 onto which material is to be deposited by evaporation or sputtering.

A source 11 of an oxygen-containing gas is conected to the chamber 1 via a valve 12.

A first electromagnetic radiation source 6 capable of producing ultraviolet radiation is positioned outside the chamber 1 so as to enable ultraviolet radiation from the source 6 to be directed through a window 7 of the chamber 1 towards a substrate 5 mounted on the second support 4.

A second electromagnetic radiation source 8 is positioned outside the chamber 1 so as to enable radiation from the source 8 to be directed through the window 7a towards a substrate 5 mounted on the second support 4.

The first electromagnetic radiation source 6 provides electromagnetic radiation having a wavelength or range of wavelengths capable of causing photolytic dissociation of oxygen containing gas introduced into the chamber from the source 11 and may, for example, be a pulsed or continuous wave (CW) laser or an incoherent UV source with a wavelength which is typically in the range of from 160nm to 250nm. The second electromagnetic radiation source 8 is provided to enable optical features characteristic of a desired oxide layer to be detected and may be a pulsed or CW laser or an incoherent source, for example a lamp and spectrometer.

A detector 9 is provided to detect radiation from the second source 8 reflected from the substrate and passing through a window 7b of the chamber 1. The detector 9 provides a signal to a control unit 10 which comprises level detection and servo-control circuitry for controlling operation of the first radiation source 6 and/or the valve 12.

As in conventional sputtering or evaporation apparatus, a pump 13 is connected to the chamber 1 via a valve 14 to enable the necessary low pressure required for evaporation or sputtering to be obtained within the chamber 1. The chamber 1 is also provided with the conventional apparatus necessary for enabling sputtering (for example RF (radio frequency) or planar magnetron sputtering) and/or evaporation from the target or source 3, although for the sake of simplicity this is not shown in the Figure.

A method embodying the invention will now be described.

A bulk sample of a high temperature superconducting ceramic, that is a defect mixed oxide of the general formula $L_aA_bB_cO_{7-x}$, where L is selected from the group consisting of yttrium and the lanthanides or rare earths, A is selected from the group consisting of strontium, barium, and calcium, B is copper, x lies in the range $0 < x < 1$ and a, b, c, indicate the relative proportions of L, A, B and generally are in the ratio $a : b : c$ is $1 ; 2 ; 3$.

Taking for example the mixed oxide $YBa_2CU_3O_{7-x}$ $(0 < x < 1)$, a bulk sample of the mixed oxide may be prepared as described in Applied Physics Letters Vol 58 No 16 at pages 1676 to 1679.

At this stage, the appearance of the high temperature superconducting ceramic is black and the oxygen content determined by subjecting a sample of the bulk material to an oxygen content determining process such as that described in Applied Physics Letters Vol 58 No 16 at pages 1676 to 1679.

The remainder of the bulk sample is then mounted as the target or source 3 within the chamber and a substrate (composed of, for example, strontium titanate ($SrTiO_3$) or barium titanate ($BaTiO_3$)) is mounted on the second support 4. The pressure within the chamber 1 is then by operation of the pump 13 reduced to, typically, $10^{-7}$ millibars ($10^{-5}$ Pa) as for conventional sputtering and a gas mixture comprising an oxygen-containing gas such as $N_2O$ (or ozone) and argon (required for the sputtering process) is introduced from the supply 11 via the valve 12.

The sputtering equipment is activated to cause sputtering (indicated diagrammatically by arrows A in the Figure) of the source onto the substrate 5. Activation of the first electromagnetic radiation source 6 causes photolytic dissociation of the oxygen-containing gas and the thus-produced oxygen atoms are incorporated into the sputtered material being deposited on the substrate 5 as a layer 15 of defect oxide.

The second electromagnetic radiation souce 8 is directed at the layer being deposited on the substrate 5 and light from the second electromagnetic radiation source reflected by the layer 15 being deposited is detected by a detector 9 which analyses the reflectance spectrum using features of the spectrum indicative of the desired oxidation state of the elements. The detector 9 sends a control signal to the control unit 10 which controls operation of the first radiation source 6 and/or the oxygen-containing gas supply valve 12. Thus, for example where the first radiation source 6 is a pulsed laser, the pulse repetition rate may be increased (or decreased) if the oxygen content of the film or layer being deposited is determined to be too low (or too high) or in other circumstances the intensity of the first radiation source may be appropriately adjusted. Similarly, the valve 12 may be controlled to increase or decrease the supply of oxygen containing gas if the oxygen content of the layer being deposited is determined to be too low or too high respectively. By means of this feedback arrangement, the oxygen content of the deposited film can be adjusted to the desired value.

In the present case, where the defect oxide is of the general formula $L_aA_bB_cO_{7-x}$ (where B is copper), the control unit 10 may determine the oxygen content of the layer 15 being deposited by comparing the reflectance spectrum of the layer 15 detected by the detector 9 with that of a control sample, for example a bulk sample, of the defect oxide material having the desired oxygen content by, for example, looking for features in the spectrum characteristic of the oxidation state of copper.

As an alternative or in addition to the above, the oxygen content of the layer 15 being deposited may be monitored via the electrical properties of the layer, for example by measuring the resistivity or magnetic susceptibility of the layer 15. Thus, as an example, the optimum resistivity at room temperature for obtaining $YBa_2Cu_3O_{7-x}$ which is superconducting at 90-100K is a few milli-ohm-cm, the resistivity being much higher if the oxygen content of the layer being deposited is too high or too low to obtain the desired high temperature superconductor. The oxygen content of the layer 15 being deposited can therefore be adjusted to that desired by monitoring the resistivity and comparing the detected resistivity with the required resistivity to provide a feedback control signal for enabling adjustment of the oxygen pressure and/or the intensity (or duration) of the electromagnetic radiation from the first source 6 to achieve the required resistivity. It may also be possible if the sputtering or evaporation apparatus can be maintained below the desired superconducting temperature to monitor the oxygen content of the layer 15 by monitoring the transition to superconductivity.

Figure 2 illustrates schematically apparatus for carrying out a second embodiment of the method wherein the oxygen-annealing is conducted after formation of the compound which will become superconductive upon proper annealing, but at a lower temperature and for a shorter time than was required by the known techniques.

The apparatus illustrated in Figure 2 comprises an image head 30 having a pair of elliptic reflectors 20 with an ultra violet lamp 21 placed at the focus of each reflector 20. The reflectors 20 are each part-cylindrical with the axis of each cylinder perpendicular to the plane of the paper having, as shown, in cross section the shape of part of an ellipse and the lamps 21 are tubular so that a coincident line image 19 is formed at the plane of a sample 22 to be processed. A viewing system 24, for reflectivity or emissivity measurements, is placed in the gap between the two reflectors 20. A set of bias lamps 25 provides a suitable ambient temperature, for example 80 to 100 degrees Celsius with the focussed ultra-violet lamps 21 providing the energy required for photolytic breakdown of the oxygen flowing through a quartz chamber 26 in which the sample 22 is placed. The inlet for the oxygen is indicated by numeral 27, and the outlet by 28. The quartz chamber 26 is transparent to the ultra-violet radiation. The bias heater 25 provides an ambient elevated temperature for the sample to avoid thermal shock when the ultra-violet lamps 21 are switched on and off.

In a specific example, which is not to be considered limiting, for a 5 micrometre thin film of $YBa_2Cu_3O_{7-x}$ prepared in the conventional manner, with $0 < x < 0.5$, the oxygen flow rate was 15 to 30 standard cubic feet per hour (0.43 to 0.85 $m^3$ per hour) the bias temperature was 80C, the maximum sample temperature during the anneal was 475C± 10C, a moderate temperature compared with the prior art annealing temperature, and with an overall anneal time of 200 seconds for a 1 cm X 1 cm sample. During this period, the line image was scanned across the sample at a scan rate of .0 5 mm/s, achieved by moving the image head 30 in the direction indicated by arrow 31. After conclusion of the annealing treatment, it was found that the sample exhibited superconductivity which it had not prior to the annealing treatment. The $T_c$ was 82K. As an indication of the improvement obtained, if the normal prior art annealing treatment were carried out for this sample, it would have required a total anneal time of at least 4 hours at 950C.

The above described methods may be used to correct the oxygen content of a layer deposited on a substrate by evaporation and/or sputtering from a bulk sample having the correct oxygen content for superconductivity or having an oxygen content which is not quite correct.

The above described methods may be applied to other high temperature superconductor mixed oxides of the general formula $L_aA_bB_cO_{7-x}$ (where L is one or a mixture of two or more of the elements in the group consisting of the lanthanides and yttrium, A is selected from the group consisting of calcium, strontium and barium or a mixture of two or all the group, B is copper and $0 < x < 1$) to facilitate the precise control of the oxygen deficiency required for these mixed defect oxides to be high temperature superconductors.

The methods described above may also be used with other high temperature superconductor defect oxides, such as $La_2CuO_4$ : (Ba, Sr) and with defect oxides which are not necessarily high temperature superconductors such as $BaPb_{1-x}Bi_xO_3$ niobium doped $SrTiO_3$ lithium niobate, bismuth silicon oxide, tungsten bronzes.

Also, a method embodying the invention may be applied where the bulk material is deposited on the substrate by evaporation spray pyrolysis or plasma spraying. Furthermore, a method embodying the invention may be used to adjust the oxygen content of an already formed film or layer especially where the already-formed film or layer comprises a porous layer or film of high temperature superconductor defect mixed oxide as the porosity of the film or layer should facilitate incorporation of oxygen. Further, although in the method described above the first electromagnetic radiation source causes photolytic dissociation of the oxygen-containing gas to provide oxygen atoms, it may be arranged to provide oxygen ions or radicals.

From reading the present disclosure, other modifications will be apparent to persons skilled in the art. Such modifications may involve other features which are already known in the formation of oxide layers on substrates and which may be used instead of or in addition to features already described herein. Although claims have been formulated in the application to particular combinations of features, it should be understood that the scope of the disclosure of the present application also includes any novel feature or any novel combination of features disclosed herein either explicitly or implicitly or any generalisation or modification of one or more of those features whether or not it relates to the same invention as presently claimed and whether or not it mitigates any or all of the same technical problems as does the present invention.

## Claims

1. A method of forming an oxide layer on a substrate, which method comprises supplying an oxygen-containing gas to a chamber containing a substrate, providing defect oxide material within the chamber and irradiating the substrate with an electromagnetic radiation source to cause photolytic dissociation of the oxygen-containing gas to provide oxygen atoms in the vicinity of defect oxide material within the chamber so that oxygen atoms are incorporated in the defect oxide material to provide a layer of defect oxide material with a desired oxygen content on the substrate.

2. A method according to Claim 1, which comprises using an ultra-violet source as the electromagnetic radiation source.

3. A method according to Claim 1 or 2, which comprises providing the defect structure oxide material as a layer on the substrate.

4. A method according to Claim 1 or 2, which comprises providing the defect oxide material by causing defect oxide material to be deposited onto the substrate whilst irradiating the chamber to cause photolytic dissociation of the oxygen-containing gas to provide oxygen atoms to be incorporated in the material being deposited.

5. A method according to Claim 4 which comprises sputtering the defect oxide material onto the substrate.

6. A method according to Claim 4, which comprises using spray pyrolysis or plasma spraying to deposit the defect oxide material onto the substrate.

7. A method according to Claim 1 or 2, which comprises using detecting means to provide a signal indicating the oxidation state of defect oxide material on the substrate, and supplying the signal to control means for controlling the electromagnetic radiation source and/or the supply of oxygen-containing gas.

8. A method according to Claim 7, wherein the detecting means comprises a further electromagnetic radiation source directed at the substrate and means for detecting electromagnetic radiation from the further electromagnetic radiation source reflected from the defect oxide material on the substrate.

9. A method according to claim 1 or 2 which comprises using detecting means to provide a signal indicating the resistivity and/or the magnetic susceptibility of the defect oxide material on the substrate and supplying the signal to control means for controlling the electromagnetic radiation source and/or the supply of oxygen-containing gas.

10. A method according to claim 1 or 2, wherein the defect oxide material comprises a mixed oxide.

11. A method according to Claim 10, wherein the defect oxide material is selected so that the layer of defect oxide material with the desired oxygen content has high temperature superconducting properties.

12. A method according to Claim 11, wherein the defect oxide material comprises oxides of copper and one or more of the elements of the group consisting of the lanthanides and yttrium.

13. A method according to Claim 12, wherein the mixed oxide is of the general formula $L_aA_bB_cO_{7-x}$, where L is selected from the group consisting of yttrium and the lanthanides A is selected from the group consisting of strontium, barium and calcium B is copper, x lies in the range $0 < x < 1$ and a, b, c, indicate relative proportion of L, A, B.

14. A method according to Claim 13, wherein the mixed oxide $YBa_2Cu_3O_{7-x}$ and the method comprises irradiating the substrate to cause dissociation of the oxygen-containing gas to provide on the substrate a layer of the mixed oxide for which x is less than or equal to 0.1 or 0.2.

15. A method according to Claim 1, wherein the oxide layer is heated to a moderate temperature, and the radiant source comprises an ultra-violet lamp focussed to a line image at the oxide layer.

16. A method according to Claim 15, wherein the line image is scanned across the oxide layer.

17. A method according to Claim 15, wherein the temperature is of the order of 400C.

**FIG.1**

**FIG.2**